# EUROPÄISCHE PATENTSCHRIFT

(11) **EP 3 422 022 B1**
(45) Veröffentlichungstag und Bekanntmachung des Hinweises auf die Patenterteilung: **14.02.2024**
(21) Anmeldenummer: 18183827.7
(22) Anmeldetag: 24.04.2006
(51) Int. Cl.: G01R 13/02

(54) **DIGITALES OSZILLOSKOP MIT DIGITALER TRIGGERUNG**
DIGITAL OSCILLOSCOPE WITH DIGITAL TRIGGERING
OSCILLOSCOPE NUMÉRIQUE À DÉCLENCHEMENT NUMÉRIQUE

(30) Priorität: 28.07.2005 DE 102005035473
(43) Veröffentlichungstag der Anmeldung: 02.01.2019
(62) Teilanmeldung aus: 06724534.0
(73) Patentinhaber: Rohde & Schwarz GmbH & Co. KG, 81671 München (DE)
(72) Erfinder: Freidhof, Markus, 85614 Kirchseeon (DE); Huber, Johann, 85570 Markt Schwaben (DE)
(74) Vertreter: Novagraaf Group

(56) Entgegenhaltungen:
- EP-A- 0 554 973
- US-A- 5 854 996
- US-B1- 6 263 290
- US-B1- 6 598 004
- US-B1- 6 753 677
- HANCOCK J: "ZEITINTERVALL-MESSGENAUIGKEIT VON DIGITAL-OSZILLOSKOPEN", ELEKTRONIK, WEKA FACHZEITSCHRIFTENVERLAG, POING, DE, Bd. 37, Nr. 1, 8. Januar 1988 (1988-01-08) , Seiten 94-97, XP000955160, ISSN: 0013-5658
- "Bisection method", WIKIPEDIA , 26. Juli 2004 (2004-07-26), XP002389052, EN.WIKIPEDIA.ORG Gefunden im Internet: URL:http://web.archive.org/web/20040726154 027/http://en.wikipedia.org/wiki/Bisection _method [gefunden am 2006-07-05]

## Beschreibung

Die Erfindung betrifft ein digitales Oszilloskop mit digitaler Triggerung.

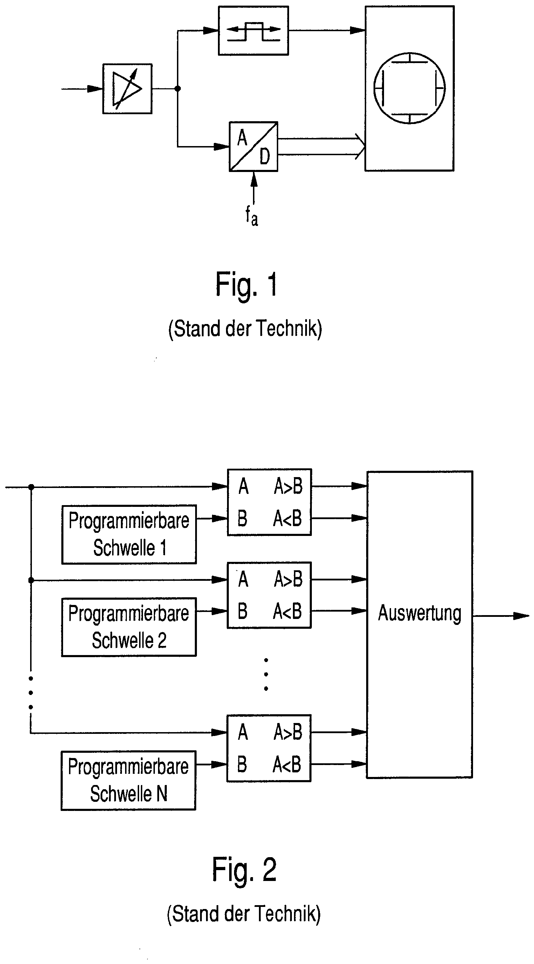

Digitale Oszilloskope bestehen gemäß Fig. 1 aus einem Eingangsverstärker, mit dessen variablen Verstärkungsfaktor die Amplitude des auf dem Oszilloskop darzustellenden Messsignals auf den Messbereich des Oszilloskops angepaßt wird, einem nachfolgenden Analog-Digital-Wandler zur Erzeugung von Abtastwerten des digitalisierten Messsignals, einer Aufzeichnungseinheit zur zeitlichen Darstellung der Abtastwerte des digitalisierten Messsignals und einem dem Analog-Digital-Wandler parallel geschalteten Triggersystem zur phasen- bzw. zeitkorrekten Darstellung des mit der Triggerschwelle des analogen Triggersystems identifizierten Signalabschnitts des Messsignals in der Aufzeichnungseinheit.

Ein analoges Triggersystem in Fig. 2 - der Einfachheit halber wird zur Triggerung im Triggersystem der Fig. 2 nur ein Messsignal herangezogen - vergleicht zur Bildung komplexerer Triggerbedingungen über mehrere Komparatoren das am jeweiligen Eingang A anliegende, hinsichtlich seiner Amplitude vorverstärkte Messsignal mit einem am Eingang B jeweils anliegenden Schwellwertsignal auf Pegel-Überschreitung bzw. -Unterschreitung. Die einstellbaren Schwellwerte 1...N werden in digitalisierter Form jeweils in einem Register gespeichert. In einer den Komparatoren nachgeschalteten Auswertungseinheit wird in Abhängigkeit der jeweils eingestellten Triggerbedingung und bei Eintreten der Triggerbedingung ein Triggersignal zur korrekten Darstellung des gewünschten Signalabschnitts des Messsignals in der Aufzeichnungseinheit erzeugt.

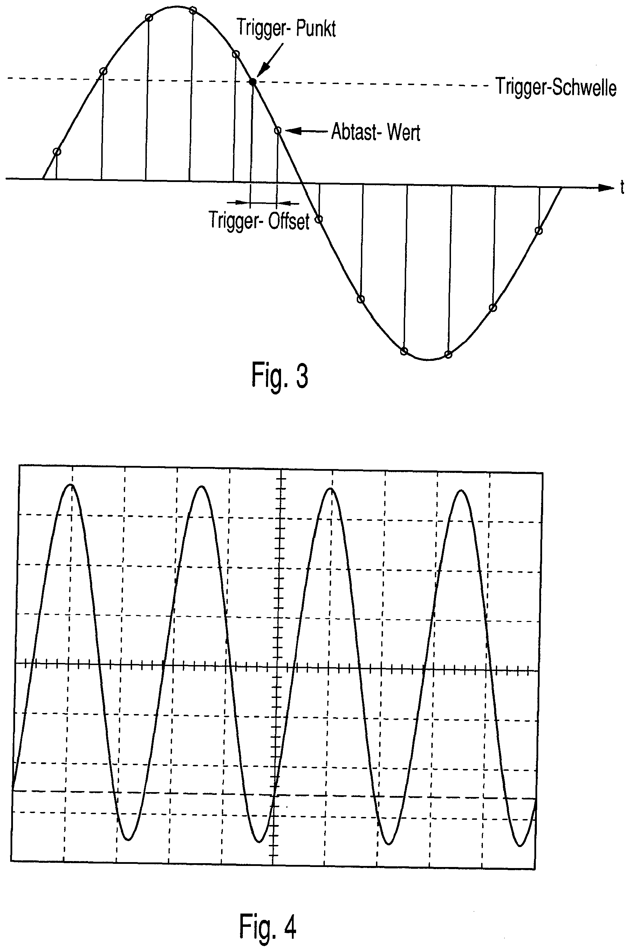

Befindet sich der Schnittpunkt des Schwellwertsignals mit dem aufzuzeichnenden Messsignal - Trigger-Punkt - zwischen zwei Abtastwerten des digitalisierten aufzuzeichnenden Messsignals, so ergibt sich gemäß Fig. 3 zwischen dem Trigger-Punkt und dem nächsten Abtastwert bzw. zwischen dem Trigger-Punkt und dem vorhergehenden Abtastwert des digitalisierten aufzuzeichnenden Messsignals ein Trigger-Offset. Dieser Trigger-Offset führt bei der Darstellung des Messsignals in der Aufzeichnungseinheit zu einem Phasenversatz zwischen dem aufzuzeichnenden Messsignal und dem Koordinatenursprung der Aufzeichnungseinheit.

Dieser Phasenversatz - Jitter - zwischen dem aufzuzeichenenden Messsignal und dem Koordinatenursprung der Aufzeichnungseinheit ist auch bei analogen Oszilloskopen bekannt und in Fig. 4 dargestellt. In Fig. 4 ist für eine Triggerschwelle von 0 V ein Jitter von 0,3 Anzeigeeinheiten auf dem Bildschirm des Oszilloskops zu erkennen.

Von analogen Oszilloskopen ist bekannt, dass dieser Jitter entweder einen konstanten Wert - systematischer Jitter - , wenn der Abstand zwischen dem Trigger-Punkt und dem nächsten Abtastwert des digitalisierten Messsignals im Fall von stationären Verhältnissen weitestgehend unverändert ist, oder einen statistischen Wert - statistischer Jitter - annehmen, wenn dem Messsignal beispielsweise ein stochastisches Phasenrauschen überlagert ist.

Neben diesen aus der zeitlichen Diskretisierung des Messsignals und stochastischem Phasenrauschen des Messsignals resultierenden Phasenfehlern in der Anzeige des Oszilloskops können unerwünschte Jitter auch aus unterschiedlichen Laufzeiten in den Messkanälen von Messsignalen resultieren, welche in Kombination zur Überprüfung der Triggerbedingung herangezogen werden. Hierbei kann es auch nachteilig vorkommen, dass die Triggerbedingung überhaupt nicht eintritt und deshalb die Messsignale erst gar nicht auf dem Bildschirm des Oszilloskops dargestellt werden.

Zusätzlich nachteilig kann die Tatsache gewertet werden, dass Phasen- bzw. Zeitfehler in den beiden Pfaden des Messsignals - Analog-Digital-Wandler bzw. Triggersystem - sich gegenseitig überlagern und im Extremfall eine Verdopplung der Wirkung hervorrufen. Eine Kompensation dieser Phasenfehler mittels Kalibrierung scheidet vielfach aus.

Aus der DE 39 36 932 A1 geht ein Triggersignalerzeuger für ein Oszilloskop hervor, der das Triggersignal auf digitalem Wege erzeugt. Weiterer Stand der Technik findet sich in den Dokumenten US6753677B1, EP0554973A, US6263290B1, US5854996A sowie HANCOCK J: "ZEITINTERVALL-MESSGENAUIGKEIT VON DIGITAL-OSZILLOSKOPEN",ELEKTRONIK,Bd. 37, Nr. 1, 8. Januar 1988, Seiten 94-97, XP000955160.

Der Erfindung liegt die Aufgabe zugrunde, ein digitales Oszilloskop zu schaffen, das eine der gewählten Triggerbedingung entsprechende, sichere Triggerung der Aufzeichnung eines oder mehrerer Messsignale auf der Anzeigeeinheit des Oszilloskops mit einer gegenüber der Abtastrate des im digitalen Oszilloskop verwendeten Analog-Digital-Wandlers höheren zeitlichen Auflösung garantiert.

Die Aufgabe wird durch die Merkmale des Anspruchs 1 gelöst. Der Unteranspruch enthält vorteilhafte Weiterbildungen der Erfindung.

Anstelle der analogen Triggerung und der damit verbundenen Nachteile wird erfindungsgemäß ein digitales Triggersystem verwendet. Hierbei werden während des Triggervorgangs nacheinander die Abtastwerte des als Referenz-Signal dienenden digitalisierten Messsignals mit einem Schwellwert verglichen. Liegt innerhalb zweier Abtastwerte eine Überschreitung des Schwellwerts durch das digitalisierte Referenz-Signal - erster Abtastwert < Schwellwert, zweiter Abtastwert > Schwellwert- oder eine Unterschreitung des Schwellwertsignals durch das digitalisierte Referenz-Signal - erster Abtastwert > Schwellwert, zweiter Abtastwert < Schwellwert -, so wird der exakte Triggerzeitpunkt in einer ersten Ausführungsform der Erfindung durch Berechnung mehrerer zusätzlicher Abtastwerte des Referenz-Signals, die zwischen den beiden Abtastzeitpunkten in äquidistanten Abstand zueinander liegen, und erneuten Vergleich aller zusätzlichen Abtastwerte des Referenz-Signals mit dem Schwellwert auf Über- oder Unterschreitung der exakte Zeitpunkt des Über- oder Unterschreitens des Schwellwerts durch das Referenz-Signal ermittelt. Auf dieses Weise kann erfindungsgemäß ein auftretender Trigger-Offset entsprechend der Anzahl gewählter zusätzlicher Abtastwerte des Referenz-Signals, die mittels Interpolation - bevorzugt mittels Polyphasenfilter - berechnet werden, minimiert werden.

Um die Anzahl der zu berechnenden zusätzlichen Abtastwerte des Referenz-Signals zu minimieren und damit eine laufzeitoptimierte Triggerung zu realisieren, wird in einer zweiten Ausführungsform der Erfindung anstelle einer festen Anzahl von zusätzlichen Abtastwerten des Referenz-Signals iterativ jeweils ein zusätzlicher Abtastwert des Referenz-Signals in der Mitte des im jeweiligen Iterationsschritt betrachteten Zeitintervalls mittels Interpolation mit Polyphasenfilter berechnet und ein Vergleich mit einem Schwellwert hinsichtlich Über- oder Unterschreitung durchgeführt. Ausgehend vom Ergebnis des Vergleichs - Über- oder Unterschreitung - wird im nächsten Iterationsschritt das vom jeweiligen zusätzlichen Abtastwert des Referenz-Signals links- oder rechtsseitig liegende halbierte Zeitintervall weiterverwendet.

Schließlich wird in einer dritten Ausführungsform der Erfindung nach iterativer Halbierung der Zeitintervalle entsprechend der zweiten Ausführungsform der Erfindung ein zusätzlicher Abtastwert des Referenz-Signals im Zeitintervall des letzten Iterationsschritts mittels linearer Interpolation berechnet.

Wird ein Triggerzeitpunkt zwischen jeweils zwei aufeinander folgenden Abtastwerten des digitalisierten Messsignals aufgrund fehlender Über- oder Unterschreitung des Schwellwerts durch das Referenz-Signal fehlerhaft nicht identifiziert (Schwellwert liegt entweder oberhalb oder unterhalb von beiden aufeinander folgenden Abtastwerten des Referenz-Signals), so sind erfindungsgemäß in einer vierten Ausführungsform der Erfindung zusätzliche Abtastwerte des Referenz-Signals zwischen den beiden Abtastzeitpunkten mittels Interpolation mit Polyphasenfilter zu berechnen, um ein mögliches Über- oder Unterschreiten des Schwellwerts durch zwei aufeinanderfolgende (zusätzliche) Abtastwerte des Referenz-Signals zu identifizieren.

Um die Anzahl von zu berechnenden zusätzlichen Abtastwerten des Referenz-Signals zu minimieren, werden in einer fünften Ausführungsform der Erfindung durch iterative Halbierung des Zeitintervalls, anschließende Berechnung eines in der Mitte des jeweiligen Zeitintervalls befindlichen zusätzlichen Abtastwerts des Referenz-Signals und Vergleich des zusätzlichen Abtastwerts des Referenz-Signals mit dem Schwellwert die Anzahl durchzuführender Berechnungen gegenüber der vierten Ausführungsform der Erfindung deutlich minimiert.

Analog zur dritten Ausführungsform der Erfindung gibt es auch eine sechste Ausführungsform, in der im letzten Iterationsschritt der zusätzliche Abtastwert des Referenz-Signals mittels linearer Interpolation aus den in den beiden vorhergehenden Iterationsschritten durch Interpolation mittels Polyphasenfilter berechneten zusätzlichen Abtastwerten des Referenz-Signals bestimmt wird.

Um die Empfindlichkeit des Triggersystems zu reduzieren, wird ein Vergleich mit zwei Schwellwerten - entspricht einem Komparator mit Hysterese - durchgeführt. Im Fall einer Überschreitung wird der obere Schwellwert verwendet, während im Fall der Unterschreitung der untere Schwellwert Verwendung findet.

Unterschiedliche Laufzeiten in den zu den einzelnen Messsignalen gehörigen Messkanälen werden über einen Kalibrierungsvorgang erfaßt und erfindungsgemäß bei den einzelnen Messsignalen kompensiert, bevor das Referenz-Signal aus den einzelnen Messsignalen für die digitale Triggerung ermittelt wird bzw. bevor die Abtastwerte der einzelnen Messsignale auf dem Bildschirm des Oszilloskops dargestellt werden.

Beispielhafte Ausführungsformen des erfindungsgemäßen Verfahrens und Systems zur digitalen Triggerung für Oszilloskope werden im folgenden unter Berücksichtigung der Zeichnung näher erläutert. In der Zeichnung zeigen:
- Fig. 1: ein Blockschaltbild eines digitalen Oszilloskops mit einem analogen Triggersystem nach dem Stand der Technik,
- Fig. 2: ein Blockschaltbild eines analogen Triggersystems nach dem Stand der Technik,
- Fig. 3: einen Zeitverlauf eines digitalisierten Messsignals mit Trigger-Offset,
- Fig. 4: eine grafische Darstellung einer Anzeigeeinrichtung eines Oszilloskops mit fehlerhaft dargestelltem Messsignal mit analoger Triggerung,
- Fig. 5: ein Blockschaltbild eines digitalen Oszilloskops mit erfindungsgemäßem digitalen Triggersystem,
- Fig. 6A,6B,6C: ein Blockschaltbild einer ersten, zweiten und dritten Ausführungsform einer erfindungsgemäßen digitalen Triggersignal-Erzeugungs-Einheit,
- Fig. 7A,7B,7C,7D: ein Blockschaltbild einer ersten, zweiten, dritten und vierten Ausführungsform eines erfindungsgemäßen Systems zur digitalen Triggerung,
- Fig. 8A,8B,8C: ein Flußdiagramm einer ersten, zweiten und dritten Ausführungsform eines erfindungsgemäßen Verfahrens zur digitalen Triggersignal-Erzeugung,
- Fig. 9A,9B,9C,9D: ein Flußdiagramm einer ersten, zweiten, dritten und vierten Ausführungsform eines erfindungsgemäßen Verfahrens zur digitalen Triggerung,
- Fig. 10A,10B,10C: ein Flußdiagramm der vierten, fünften und sechsten Ausführungsform eines erfindungsgemäßen Verfahrens zur digitalen Triggersignal-Erzeugung,
- Fig. 11A, 11B: einen Zeitverlauf eines digitalisierten Messsignals gemäß der ersten und zweiten Ausführungsform des erfindungsgemäßen Verfahrens bzw. Systems zur digitalen Triggerung und
- Fig. 12A, 12B: einen Zeitverlauf eines digitalisierten Messsignals gemäß der vierten und fünften Ausführungsform des erfindungsgemäßen Verfahrens bzw. Systems zur digitalen Triggersignal-Erzeugung.

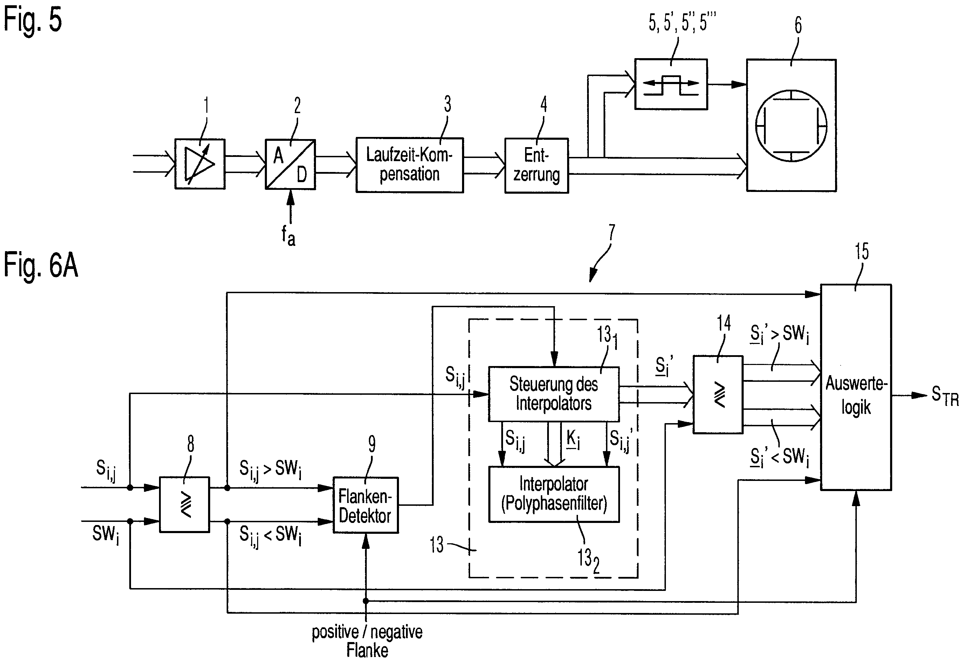

Das erfindungsgemäße digitale Oszilloskop in Fig. 5 führt mit einem Vorverstärker 1, der einen veränderlichen Verstärkungsfaktor aufweist, eine Pegelanpassung der Amplitude des an seinem Eingang anliegenden Messsignale an den Messbereich der Anzeigeeinrichtung 5 durch. Nach der Pegelanpassung werden die vorverstärkten analogen Messsignale einem Analog-Digital-Wandler 2 zur Wandlung in ein korrespondierendes digitales Datenformat zugeführt. Eine anschließende Einheit zur Kompensation von Laufzeiten 3 kompensiert unterschiedliche Laufzeiten in den zu den einzelnen Messsignalen gehörigen Messkanälen. Optional folgt ein Entzerrungssystem 4, das eine Entzerrung der linear bzw. nichtlinear verzerrten digitalisierten Messsignale durchführt. Die linearen bzw. nichtlinearen Verzerrungen der Messsignale resultieren aus dem Übertragungsverhalten der Übertragungsglieder des gesamten Messkanals (Messköpfe, Messleitungen, Vorverstärker und Analog-Digital-Wandler).

Das digitalisierte Messsignal wird nach der Entzerrung von einem erfindungsgemäßen digitalen Triggersystem 5 hinsichtlich einer einstellbaren Triggerbedingung geprüft und bei Identifizierung dieser Triggerbedingung wird am Messsignal ein Triggersignal zur Triggerung des Digitaloszilloskops am Ausgang des digitalen Triggersystems 5 erzeugt. Diejenigen Abtastwerte des digitalisierten entzerrten Messsignals werden auf einem Bildschirm der Aufzeichnungseinheit 6 des digitalen Oszilloskops dargestellt, die gleichzeitig mit dem Triggersignal oder zeitlich dem Triggersignal unmittelbar nachfolgend erfaßt werden.

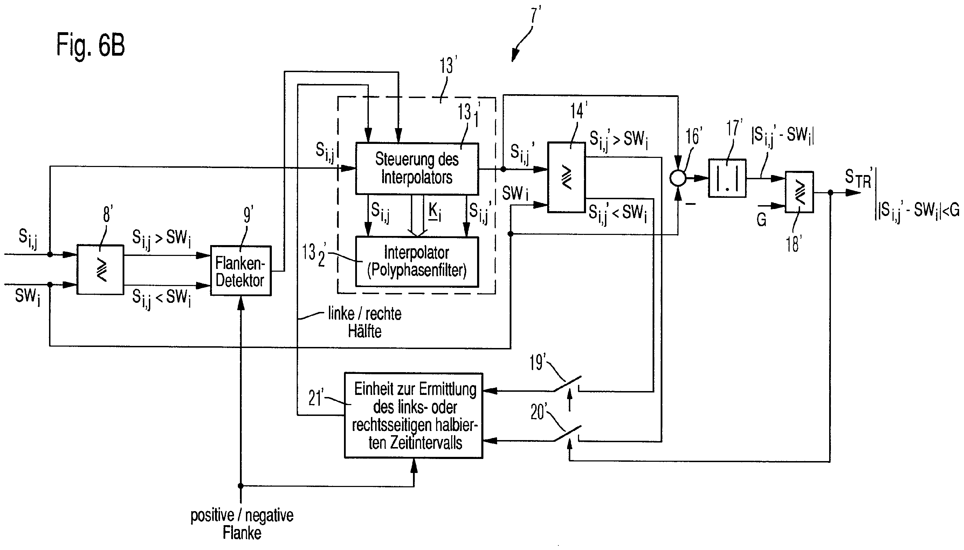

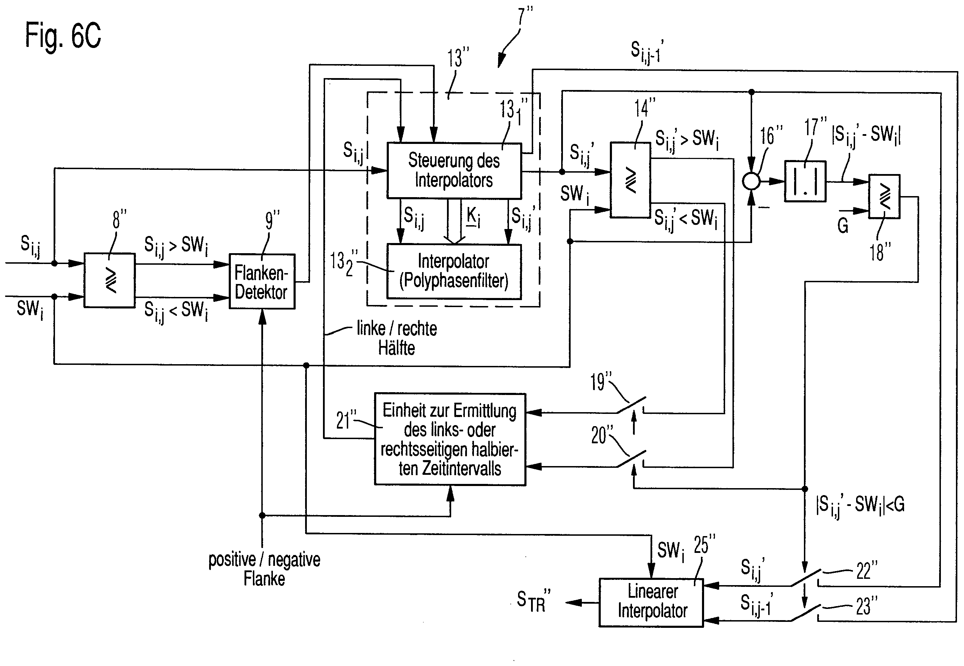

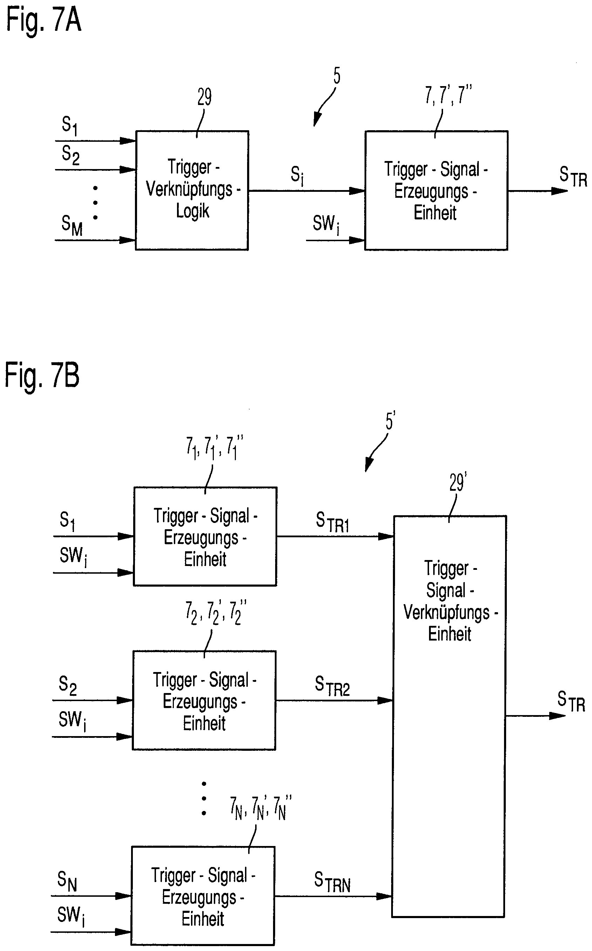

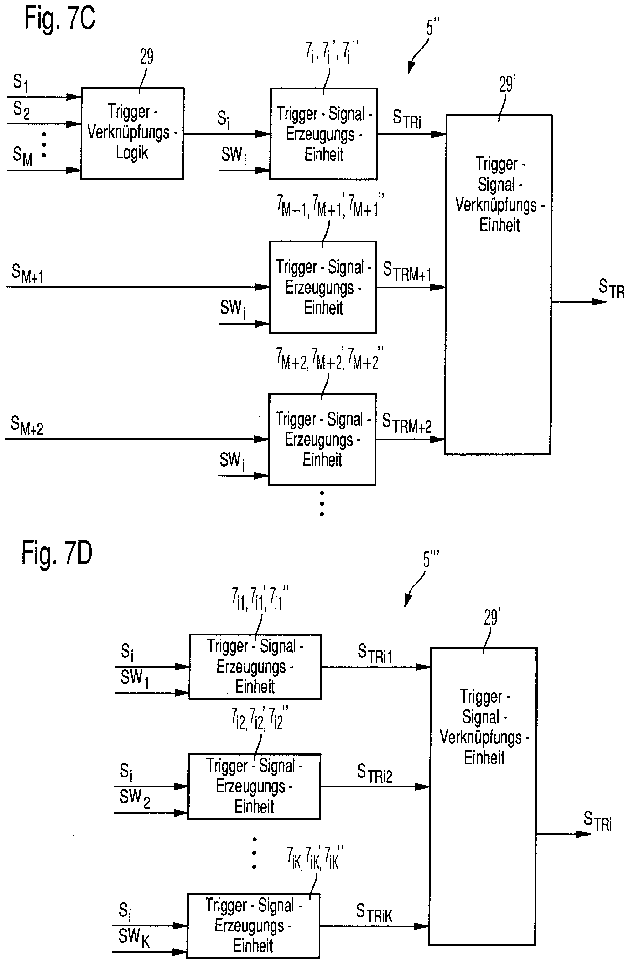

Bevor in den Figuren 7A, 7B, 7C und 7D der Zeichnung die erste, zweite, dritte und vierte Ausführungsform eines erfindungsgemäßen Systems zur digitalen Triggerung beschrieben wird, wird im folgenden anhand der Figuren 6A, 6B und 6C die allen diesen Ausführungsformen eines erfindungsgemäßen Systems zur digitalen Triggerung alternativ innewohnende erste, zweite und dritte Ausführungsform einer Triggersignal-Erzeugungseinheit vorgestellt:
In einer ersten Ausführungsform 7 einer digitalen Triggersignal-Erzeugungseinheit in Fig. 6A wird ein Signal Si aus mehreren in einem digitalen Oszilloskop darzustellenden Signalen S als Referenz-Signal Si zur Erzeugung eines Triggersignals S_{TR} herangezogen. Hierzu werden die Abtastwerte S_{i,j} des Referenz-Signals Si und ein Schwellwert SWᵢ an jeweils einen Eingang eines Komparators 8 geführt. Der Komparator 8 vergleicht den Abtastwert S_{i,j} des digitalisierten Referenz-Signals Si mit dem Schwellwert SWᵢ und aktiviert einen ersten Ausgang im Fall einer Überschreitung des Schwellwert SWᵢ durch den Abtastwert S_{i,j} des Referenz-Signals Sᵢ bzw. einen zweiten Ausgang im Fall einer Unterschreitung des Schwellwerts SWᵢ durch den Abtastwert S_{i,j} des Referenz-Signals Sᵢ.

In einem dem Komparator 8 nachgeschalteten Flankendetektor 9 wird in Abhängigkeit einen positiven oder negativen Flankentriggerung und den beiden Signalen an den beiden Ausgängen des Komparators 8 eine Über- oder Unterschreitung des Schwellwerts SWᵢ durch zwei aufeinander folgende Abtastwerte S_{i,j} und S_{i,j+1} des Referenz-Signals Sᵢ durch Aktivierung des Ausgangs des Flankendetektors 9 identifiziert.

Die Abtastwerte S_{i,j} des Referenz-Signals Si werden einer Einheit 13 zur Bestimmung zusätzlicher, äquidistant zwischen zwei aufeinanderfolgenden Abtastwerten S_{i,j} und S_{i,j-1} befindlicher Abtastwerte Sᵢ' des Referenz-Signals Si zugeführt. Diese Einheit 13 besteht aus dem eigentlichen Interpolator 13₂, der bevorzugt ein Polyphasenfilter ist, und einer Einheit 13₁ zur Steuerung des Interpolators.

Die Einheit 13₁ zur Steuerung des Interpolators liest die einzelnen Abtastwerte S_{i,j} des Referenz-Signals Si zyklisch ein und speichert sie zwischen. Das bei Über- oder Unterschreitung des Schwellwerts SWᵢ durch zwei aufeinander folgende Abtastwerte S_{i,j} und S_{i,j-1} des Referenz-Signals Si aktivierte Ausgangssignal des Flankendetektors 9 dient der Einheit 13₁ zur Steuerung des Interpolators zur sequentiellen Übergabe einer bestimmten Anzahl von eingelesenen und zwischengespeicherten Abtastwerten S_{i,j} des Referenz-Signals Sᵢ, die dem identifizierten Flankenereignis vor- bzw. nachgelagert sind, an den Interpolator 13₂. Zusätzlich übergibt die Einheit 13₁ zur Steuerung des Interpolators dem Interpolator 13₂ die für die Berechnung des jeweiligen zusätzlichen Abtastwerts S_{i,j}' des Referenz-Signals Si gehörigen Filterkoeffizienten Kᵢ. Der vom Polyphasenfilter 13₂ jeweils berechnete zusätzliche Abtastwert S_{i,j}' des Referenz-Signals Si wird von der Einheit 13₁ zur Steuerung des Interpolators eingelesen und zwischengespeichert. Sind vom Interpolator 13₂ alle zusätzlichen Abtastwerte S_{i,j}' des Referenz-Signals Si berechnet worden, so gibt die Einheit 13₁ zur Steuerung des Interpolators alle berechneten und zwischengespeicherten zusätzlichen Abtastwerte Sᵢ' des Referenz-Signals Si aus.

Die zusätzlichen Abtastwerte Sᵢ' des Referenz-Signals Si werden in einem nachfolgenden Komparator 14 eingelesen und jeweils mit dem Schwellwert SWᵢ verglichen. Der Komparator 14 weist für jeden der zusätzlichen Abtastwerte Sᵢ' des Referenz-Signals Si jeweils zwei Ausgänge auf, von denen der eine Ausgang jeweils bei Überschreitung des Schwellwerts SWᵢ durch den zusätzlichen Abtastwert S_{i,j}' des Referenz-Signals Si aktiviert ist, und der andere Ausgang jeweils bei Unterschreitung des Schwellwerts SWᵢ durch den zusätzlichen Abtastwert S_{i,j}' des Referenz-Signals Si aktiviert ist.

Eine abschließende Auswertelogik 15 ermittelt in Abhängigkeit einer positiven oder negativen Flankentriggerung und den an den einzelnen Ausgängen des Komparators 14 anliegenden Signalen denjenigen zusätzlichen Abtastwert S_{i,j}' des Referenz-Signals Sᵢ, der den kürzesten Abstand zum Schwellwert SWᵢ aufweist und den gesuchten Triggerzeitpunkt für das Trigger-Signal S_{TR} darstellt.

Um die Vielzahl von nötigen zusätzlichen Abtastwerten Sᵢ' des Referenz-Signals Si der ersten Ausführungsform 7 einer Triggersignal-Erzeugungseinheit zu minimieren, wird im folgenden anhand von Fig. 6B eine zweite Ausführungsform 7' einer Triggersignal-Erzeugungseinheit beschrieben, welche für die Bestimmung des Triggerzeitpunkts eine minimierte Anzahl von zusätzlichen Abtastwerten Si' des Referenz-Signals Si benötigt.

Die zweite Ausführungsform 7' der Triggersignal-Erzeugungseinheit vergleicht äquivalent der ersten Ausführungsform 7 der Triggersignal-Erzeugungseinheit in einem Komparator 8' die einzelnen Abtastwerte S_{i,j} des Referenz-Signals Sᵢ, welches aus mehreren auf dem digitalen Oszilloskop darzustellenden Signalen S ausgewählt wird, mit dem Schwellwert SWᵢ. Der Vergleich führt zu einer Aktivierung eines ersten Ausgangs des Komparators 8' im Fall einer Überschreitung des Schwellwerts SWᵢ durch jeweils zwei aufeinander folgende Abtastwerte S_{i,j} und S_{i,j-1} des Referenz-Signals Sᵢ und zu einer Aktivierung eines zweiten Ausgangs des Komparators 8' im Fall einer Unterschreitung des Schwellwerts SWᵢ durch jeweils zwei aufeinander folgende Abtastwerte S_{i,j} und S_{i,j-1} des Referenz-Signals Sᵢ. Ein dem Komparator 8' nachfolgender Flankendetektor 9' ermittelt aus den beiden am ersten oder zweiten Ausgang des Komparators 8' anliegenden Signalen, ob in Abhängigkeit einer positiven oder negativen Flankentriggerung eine Überschreitung oder Unterschreitung des Schwellwerts SWᵢ durch jeweils zwei aufeinander folgende Abtastwerte S_{i,j} und S_{i,j-1} des Referenz-Signals Si vorliegt und aktiviert im Falle einer Überschreitung oder Unterschreitung den Ausgang des Flankendetektors 9'.

Die Abtastwerte S_{i,j} des Referenz-Signals Si werden einer Einheit 13' zur Bestimmung zusätzlicher, zwischen zwei aufeinanderfolgenden Abtastwerten S_{i,j} und S_{i,j-1} befindlicher Abtastwerte Sᵢ' des Referenz-Signals Si zugeführt. Diese Einheit 13' besteht aus dem eigentlichen Interpolator 13₂', der bevorzugt ein Polyphasenfilter ist, und einer Einheit 13₁' zur Steuerung des Interpolators.

In der Einheit 13' zur Bestimmung zusätzlicher Abtastwerte Sᵢ' des Referenz-Signals Sᵢ wird mittels Interpolation in einem Polyphasenfilter in Anlehnung an die erste Ausführungsform im ersten Iterationsschritt der zusätzliche Abtastwert S_{i,j}' des Referenz-Signals Si in der Mitte des Zeitintervalls ermittelt, das durch die beiden dem identifizierten Flankenereignis jeweils vor- und nachgelagerten Abtastwerten S_{i,j} und S_{i,j-1} des Referenz-Signals Si bestimmt wird. In allen folgenden Iterationsschritten j ermittelt die Einheit 13 zur Bestimmung zusätzlicher Abtastwerte Sᵢ' des Referenz-Signals Si den zusätzlichen Abtastwert S_{i,j}' des Referenz-Signals Si in der Mitte des Zeitintervalls, das durch den im vorhergehenden Iterationsschritt j-1 ermittelten zusätzlichen Abtastwert S_{i,j-1}' des Referenz-Signals Si und derjenigen im vorhergehenden Iterationsschritt j-1 ermittelten Zeitintervallsgrenze festgelegt wird, die in Richtung des Schwellwerts SWᵢ relativ zum im vorhergehenden Iterationsschritt j-1 ermittelten zusätzlichen Abtastwert S_{i,j-1}' des Referenz-Signals Sᵢ liegt.

In einem folgenden Komparator 14' wird der im Iterationsschritt j ermittelte zusätzliche Abtastwert S_{i,j}' des Referenz-Signals Si mit dem Schwellwert SWᵢ auf Über- oder Unterschreitung verglichen und bei Überschreitung des Schwellwerts SWᵢ durch den zusätzlichen Abtastwert S_{i,j}' des Referenz-Signals Si ein erster Ausgang und bei Unterschreitung des Schwellwerts SWᵢ durch den zusätzlichen Abtastwert S_{i,j}' des Referenz-Signals Si ein zweiter Ausgang aktiviert.

Aus dem in der Einheit 13' zur Bestimmung zusätzlicher Abtastwerte Sᵢ' des Referenz-Signals Si im Iterationsschritt j ermittelten zusätzlichen Abtastwert S_{i,j}' des Referenz-Signals Si und dem Schwellwert SWᵢ wird in einem Subtrahierer 16' der Pegelabstand zwischen dem zusätzlichen Abtastwert S_{i,j}' des Referenz-Signals Si und dem Schwellwert SWᵢ gebildet, und einem nachfolgenden Betragsbildner 17' weitergeleitet. In einem weiteren Komparator 18' wird der ermittelte Betrag des Pegelabstands zwischen dem zusätzlichen Abtastwert S_{i,j}' des Referenz-Signals Si und dem Schwellwert SWᵢ mit einem Grenzwert G verglichen. Im Falle einer Unterschreitung des Grenzwerts G durch den Betrag des Pegelabstands zwischen dem zusätzlichen Abtastwert S_{i,j}' des Referenz-Signals Si und dem Schwellwert SWᵢ ist ein zusätzlicher Abtastwert S_{i,j}' des Referenz-Signals Si identifiziert, der dem Trigger-Punkt am nächsten liegt und somit den Triggerzeitpunkt eines am Ausgang des Komparators 18' erzeugtes Triggersignal S_{TR} bildet.

Solange das Triggersignal S_{TR} nicht aktiviert ist, sind die beiden Schalter 19' und 20' geschlossen und die beiden am Ausgang des Komparators 14' anliegenden Signale, die jeweils eine Über- oder Unterschreitung des Schwellwerts SWᵢ durch den im Iterationsschritt j ermittelten zusätzlichen Abtastwert S_{i,j}' des Referenz-Signals Si kennzeichnen, werden der Einheit 21' zur Ermittlung des links- oder rechtsseitig halbierten Zeitintervalls weitergeleitet. In Abhängigkeit einer Über- oder Unterschreitung des Schwellwerts SWᵢ durch den im Iterationsschritt j ermittelten zusätzlichen Abtastwert S_{i,j}' des Referenz-Signals Si wird von der Einheit 21' zur Ermittlung des links- oder rechtsseitig halbierten Zeitintervalls die vom im Iterationsschritt j ermittelten zusätzlichen Abtastwert S_{i,j}' des Referenzsignals Si links- oder rechtsseitig gelegene Hälfte des im Iterationsschritt j betrachteten Zeitintervalls für die Bestimmung des zusätzlichen Abtastwerts S_{i,j+1}' des Referenz-Signals Si im nächsten Iterationsschritt j+1 bestimmt. Die Information über die im nächsten Iterationsschritt j+1 verwendete links- oder rechtsseitige Hälfte des Zeitintervall des aktuellen Iterationsschrittes j wird von der Einheit 21' zur Ermittlung des links- oder rechtsseitigen halbierten Zeitintervalls der Einheit 13₁' zur Steuerung des Interpolators der Einheit 13' zur Bestimmung zusätzlicher Abtastwerte Sᵢ' des Referenz-Signals Si zugeführt.

Durch die iterative Halbierung des jeweiligen Zeitintervalls und den darauf aufsetzenden Pegelvergleich zwischen dem in der jeweiligen Zeitintervallsmitte befindlichen zusätzlichen Abtastwert S_{i,j}' des Referenz-Signals Si zum Schwellwert SWᵢ führt die zweite Ausführungsform der Triggersignal-Erzeugungseinheit gegenüber der ersten Ausführungsform der Triggersignal-Erzeugungseinheit zu einer minimierten Anzahl von zusätzlichen Abtastwerten Sᵢ' des Referenz-Signals Si.

Die dritte Ausführungsform 7" der erfindungsgemäßen Triggersignal-Erzeugungseinheit in Fig. 6C basiert auf der zweiten Ausführungsform 7' der erfindungsgemäßen Trigger-signal-Erzeugungseinheit in Fig. 6B, indem im letzten Iterationsschritt j+1, sobald der Betrag des Pegelabstands zwischen dem im Iterationsschritt j ermittelten, zusätzlichen Abtastwert S_{i,j}' des Referenz-Signals Si und dem Schwellwert SWᵢ einen Grenzwert G unterschreitet, über eine lineare Interpolation aus den in den beiden zurückliegenden Iterationsschritten j und j-1 ermittelten zusätzlichen Abtastwerten S_{i,j}' und S_{i,j-1}' des Referenz-Signals Si ein zusätzlicher Abtastwert S_{i,j+1}' des Referenz-Signals Si ermittelt wird, dessen Zeitwert der gesuchte Triggerzeitpunkt für das Triggersignal S_{TR}" darstellt.

Die dritte Ausführungsform 7" der erfindungsgemäßen Triggersignal-Erzeugungseinheit in Fig. 6C weist hierzu die identischen Funktionseinheiten zur zweiten Ausführungsform 7' der erfindungsgemäßen Triggersignal-Erzeugungseinheit auf (Bezugszeichen 8" bis 21"). Zusätzlich werden gemäß Fig. 6C die in der Einheit 13" zur Steuerung des Interpolators der Einheit 13" zur Bestimmung zusätzlicher Abtastwerte Sᵢ' des Referenz-Signals Si zwischengespeicherten zusätzlichen Abtastwerte S_{i,j}' und S_{i,j-1}' des Referenz-Signals Sᵢ über die beiden Schalter 22" und 23" dem linearen Interpolator 25" zugeführt, sobald der Komparator 18" ein Unterschreiten des Betrags des Pegelabstands zwischen dem im Iterationsschritt j ermittelten zusätzlichen Abtastwert S_{i,j}' des Referenz-Signals Si und dem Schwellwert SWᵢ identifiziert hat. Der lineare Interpolator 25" ermittelt aus den zusätzlichen Abtastwerten S_{i,j}' und S_{i,j-1}' des Referenz-Signals Si und ihren zugehörigen Abtastzeitpunkten sowie dem Schwellwert SWᵢ über eine lineare Interpolation einen den Schnittpunkt zwischen Schwellwert SWᵢ und Referenz-Signal Si im "Nahbereich" als Triggerzeitpunkt des Triggersignals s_{TR}".

Mit der in den Figuren 6A, 6B und 6C dargestellten ersten, zweiten und dritten Ausführungsform 7, 7', 7" der erfindungsgemäßen Triggersignal-Erzeugungseinheit werden im folgenden in den Figuren 7A, 7B, 7C und 7D die erste, zweiten, dritte und vierte Ausführungsform 5, 5', 5" und 5‴ des erfindungsgemäßen Systems zur digitalen Triggerung vorgestellt:
In einer ersten Ausführungsform 5 des erfindungsgemäßen Systems zur digitalen Triggerung in Fig. 7A werden zur Bildung eines Referenz-Signals Si über eine vorausgehende Triggerverknüpfungslogik 29 mehrere Signale S₁, S₂, ...,S_{M} aus allen am digitalen Oszilloskop darzustellenden Signalen S verknüpft. Das Referenz-Signal Si wird mit einem Schwellwert SWᵢ in einer Triggersignal-Erzeugungseinheit 7, 7' oder 7" gemäß Fig. 6A, 6B und 6C hinsichtlich Über- oder Unterschreitung im Hinblick auf die Ermittlung eines vergleichsweise exakten Triggerzeitpunkts verglichen. Mit Eintritt des vergleichsweise exakten Triggerzeitpunkts wird ein Triggersignal S_{TR} am Ausgang der Triggersignal-Erzeugungseinheit 7, 7' oder 7'' aktiviert.

Bei der vorausgehenden Triggerverknüpfungslogik 29 kann es sich um alle möglichen Arten von arithmetischen und logischen Verknüpfungen handeln. Mit der ersten Ausführungsform 5 des erfindungsgemäßen Systems zur digitalen Triggerung ist es insbesondere möglich, ein differenzielles Signal erfindungsgemäß als Referenz-Signal Si zu verwenden. Hierbei werden die beiden Teilsignale des differenzielles Signals jeweils mit einem Messtaster auf Massepotential bezogen gemessen, über einen Analog-Digital-Wandler in ein korrespondierendes digitales Datenformat gewandelt und zur Bildung des digitalen differenziellen Signals von der Triggerverknüpfungslogik 29 jeweils eingelesen und über eine digital realisierte Differenzbildung voneinander subtrahiert.

In einer zweiten Ausführungsform 5' des erfindungsgemäßen Systems zur digitalen Triggerung in Fig. 7B werden die für die Triggerung herangezogenen Signale S₁, S₂, ..., S_{N} aus allen am digitalen Oszilloskop darzustellenden Signalen S jeweils als Referenz-Signale in einer jeweiligen Triggersignal-Erzeugungseinheit 7₁, 7₁', 7₁", 7₂, 7₂', 7₂",..., 7_{N}, 7_{N}', 7_{N}" jeweils mit dem gleichen Schwellwert SWᵢ auf Über- oder Unterschreitung zur Bestimmung eines zugehörigen Triggerzeitpunkts für ein zugehöriges Triggersignal S_{TR1}, S_{TR2},..., S_{TRN} verglichen. In einer nachfolgenden Triggersignal-Verknüpfungseinheit 29' werden die einzelnen Triggersignale S_{TR1}, S_{TR2},..., S_{TRN} zu einem kombinierten Triggersignal S_{TR} miteinander arithmetisch und/oder logisch verknüpft.

Die zweite Ausführungsform 5' des erfindungsgemäßen Systems zur digitalen Triggerung in Fig. 7B findet Verwendung, wenn jedes einzelne für die digitale Triggerung herangezogene Signal mit einem identischen Schwellwert zur Bestimmung eines signalspezifischen Triggerzeitpunkts verglichen wird. Auf diese Weise läßt sich ein Triggersignal generieren, das im Gegensatz zur ersten Ausführungsform 5 in Fig. 7A eine auf mehreren Referenz-Signalen basierende komplexere Triggersignal-Generierung realisiert.

Die dritte Ausführungsform 5" des erfindungsgemäßen Systems zur digitalen Triggerung in Fig. 7C stellt eine Kombination der ersten und zweiten Ausführungsform des erfindungsgemäßen Systems zur digitalen Triggerung in Fig. 7A und 7B dar.

In der vorausgehenden Triggerverknüpfungslogik 29 werden mehrere Signale S₁, S₂, ..., S_{M} aus mehreren am digitalen Oszilloskop darzustellenden Signalen S_ mit ihrem Referenz-Signal Si arithmetisch und/oder logisch verknüpft. Das Referenz-Signal Si sowie zwei oder mehrere weitere als Referenz-Signale dienende Signale S_{M+1,} S_{M+2}, ... aus mehreren am digitalen Oszilloskop darzustellenden Signalen S werden jeweils in einer ersten, zweiten oder dritten Ausführungsform einer digitalen Triggersignal-Erzeugungseinheit 7i, 7ᵢ', 7ᵢ", 7_{M+1,} 7_{M+1}', 7_{M+1}", 7_{M+2}, 7_{M+2}', 7_{M+2}",... mit jeweils einem identischen Schwellwert SWᵢ auf Über- oder Unterschreitung verglichen. Die zum jeweils ermittelten Triggerzeitpunkt aktivierten Triggersignale S_{TRi}, S_{TRM+1,} S_{TRM+2}, ... werden in einer nachfolgenden Triggersignal-Verknüpfungseinheit 29' zu einem kombinierten Triggersignal S_{TR} miteinander arithmetisch und/oder logisch verknüpft.

In einer vierten Ausführungsform 5‴ des erfindungsgemäßen Systems zur digitalen Triggerung in Fig. 7D wird ein für die Triggerung herangezogenes Signal Si in jeweils einer Triggersignal-Erzeugungseinheit 7ᵢ₁, 7ᵢ₁', 7ᵢ₁", 7ᵢ₂, 7ᵢ₂', 7ᵢ₂", ..., 7_{iK}, 7_{iK}', 7_{iK}" mit jeweils einem unterschiedlichen Schwellwert SW₁, SW₂,..., SW_{K} auf Über- oder Unterschreitung verglichen. Die zum jeweils identifizierten Triggerzeitpunkt von den einzelnen Triggersignal-Erzeugungseinheiten 7ᵢ₁, 7ᵢ₁', 7ᵢ₁", 7ᵢ₂, 7ᵢ₂', 7ᵢ₂", ..., 7_{iK}, 7_{iK}', 7_{iK}" jeweils aktivierten Triggersignale S_{TRi1}, S_{TRi2}, ..., S_{TRiK} werden über eine nachfolgende Triggersignal-Verknüpfungseinheit 29' zu einem kombinierten Triggersignal S_{TR} miteinander arithmetisch und/oder logisch verknüpft.

Mit der vierten Ausführungsform 5‴ des erfindungsgemäßen Systems zur digitalen Triggerung in Fig. 7D ist es möglich, anhand eines für die Triggerung eines digitalen Oszilloskops bestimmten Signals Si eine aus mehreren Schwellwerten SW₁, SW₂,..., SW_{K} zusammengesetzte komplexere Triggerbedingung - beispielsweise Triggerung auf bestimmte Steigungen einer Signalflanke oder Korrelations-Triggerung - zu realisieren.

Der Vergleich eines einzigen Signals Si mit mehreren Schwellwerten SW₁, SW₂, ..., SW_{K} ist erfindungsgemäß auch auf ein digitales Triggersystem mit mehreren zur Triggerung bestimmten Signalen S im Sinne der zweiten und dritten Ausführungsform 5' und 5" eines erfindungsgemäßen Systems zur digitalen Triggerung in Fig. 7B und 7C übertragbar.

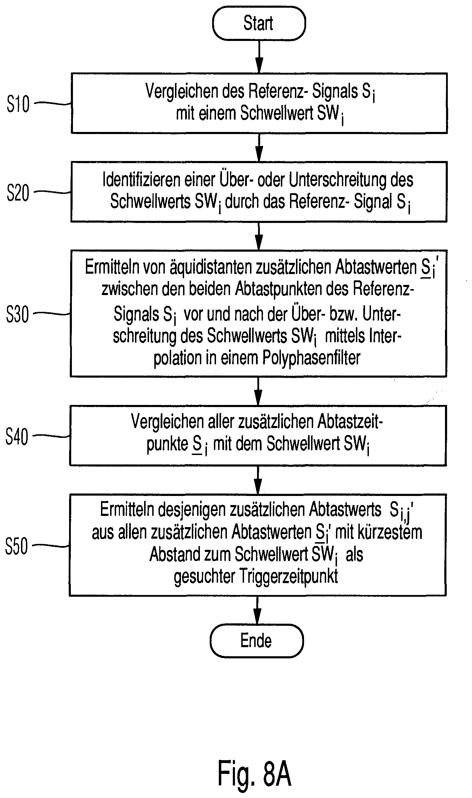

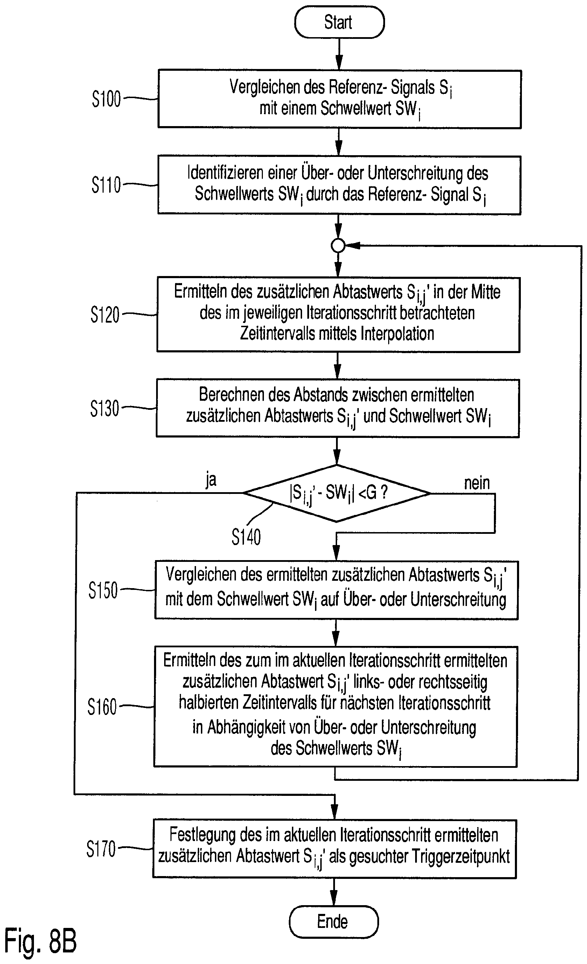

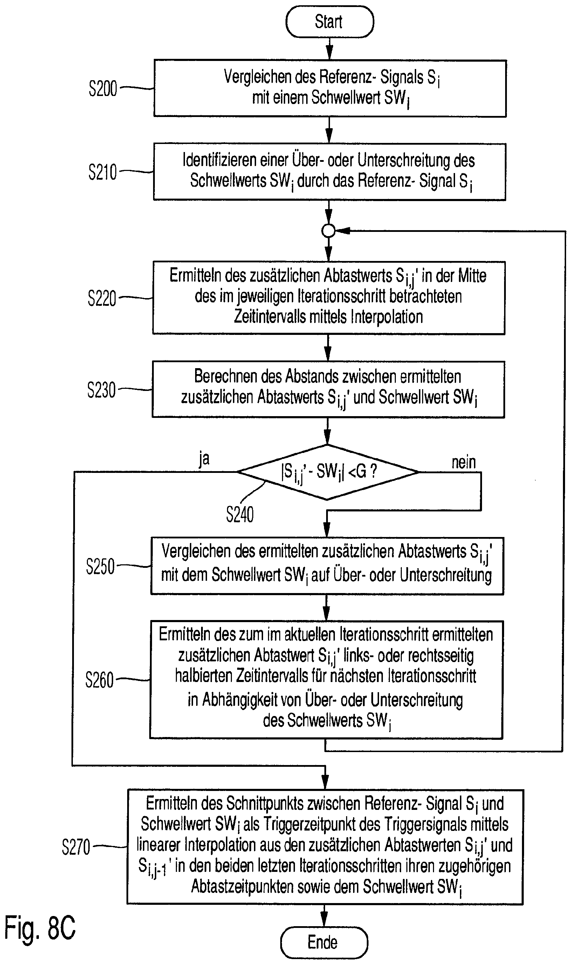

Im folgenden wird die erste, zweite und dritte Ausführungsform des erfindungsgemäßen Verfahrens zur digitalen Triggersignal-Erzeugung anhand der Figuren 8A, 8B und 8C vorgestellt:
Im ersten Verfahrensschritt S10 der ersten Ausführungsform des erfindungsgemäßen Verfahrens zur digitalen Triggersignal-Erzeugung in Fig. 8A wird mit Hilfe des Komparators 8 der Abtastwert S_{i,j} des digitalisierten Referenz-Signals Si mit dem Schwellwert SWᵢ verglichen.

Im darauffolgenden Verfahrensschritt S20 werden mit Hilfe eines Flankendetektors 9 aus dem Vergleichsergebnis des Verfahrensschritts S10 die beiden Abtastwerte S_{i,j} und S_{i,j-1} des Referenz-Signals Si identifiziert, zwischen denen eine Über- oder Unterschreitung des Schwellwerts SWᵢ durch die beiden Abtastwerte S_{i,j} und S_{i,j-1} des Referenz-Signals Si erfolgt.

Mittels Interpolation in einem Polyphasenfilter werden im Verfahrensschritt S30 die zusätzlichen Abtastwerte Si' des Referenz-Signals Si berechnet, die zwischen dem in Verfahrensschritt S20 identifizierten Abtastwerten S_{i,j} und S_{i,j-1} des Referenz-Signals Si äquidistant verteilt sind. Die Anzahl der hierbei verwendeten zusätzlichen Abtastwerte Sᵢ' des Referenz-Signals Si bestimmt die Genauigkeit des im den folgenden Verfahrensschritten ermittelten Triggerzeitpunkts. Hierbei ist ein technisch sinnvoller Kompromiß zwischen der realisierten Genauigkeit in der Bestimmung des Triggerzeitpunkts und des numerischen Rechenaufwands bei der Berechnung der zusätzlichen Abtastwerte Sᵢ' des Referenz-Signals Si mittels Interpolation zu treffen.

Die in Verfahrensschritt S30 ermittelten zusätzlichen Abtastwerte Sᵢ' des Referenz-Signals Si zwischen den beiden in Verfahrensschritt S20 identifizierten Abtastwerten S_{i,j} und S_{i,j-1} des Referenz-Signals Sᵢ werden im darauf folgenden Verfahrensschritt S40 in den Komparator 14 auf Über- oder Unterschreitung des Schwellwerts SWᵢ verglichen.

Aus den Vergleichsergebnissen des Verfahrensschritt S40 wird im abschließenden Verfahrensschritt S50 derjenige zusätzliche Abtastwerte S_{i,j}' des Referenz-Signals Si aus allen zwischen den beiden in Verfahrensschritt S20 identifizierten zusätzlichen Abtastwerte Si' des Referenz-Signals Si mit einer Auswertelogik 15 ermittelt, der den kürzesten Pegelabstand zum Schwellwert SWᵢ aufweist und somit den vergleichsweise exaktesten Triggerzeitpunkt für die Aktivierung des Triggersignals S_{TR} darstellt.

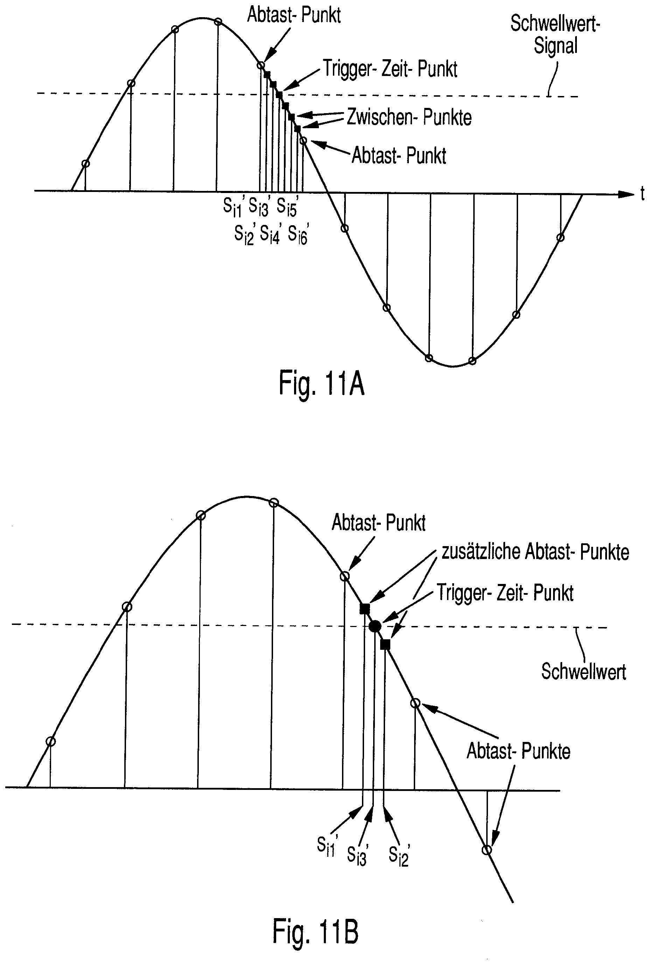

Fig. 11A zeigt am Beispiel eines sinusförmigen Signals, welches als Referenz-Signal Si dient, und eines Schwellwerts SWᵢ, wie mit Hilfe der ersten Ausführungsform des erfindungsgemäßen Verfahrens der Triggersignal-Erzeugung durch Berechnung äquidistanter zusätzlicher Abtastwerte S_{i,1}', S_{i,2}', S_{i,3}', S_{i,4}', S_{i,5}', ... zwischen zwei Abtastpunkten des sinusförmigen Signals, deren Pegel jeweils unter- und oberhalb des Pegel des Schwellwerts liegen, der zusätzliche Abtastwert S_{i,3}' des Referenz-Signals Sᵢ, der einen minimalen Abstand zum Schwellwert SWᵢ aufweist, als Triggerzeitpunkt für ein Triggersignal bestimmt wird.

Die zweite Ausführungsform des erfindungsgemäßen Verfahrens zur digitalen Triggersignal-Erzeugung in Fig. 8B weist in ihren ersten beiden Verfahrensschritten S100 und S110 die zu Verfahrensschritt S10 und S20 der ersten Ausführungsform des erfindungsgemäßen Verfahrens zur digitalen Triggersignal-Erzeugung in Fig. 8A identische Verfahrensweise auf.

Im darauf folgenden Verfahrensschritt S120 wird im ersten Iterationsschritt der zusätzliche Abtastwert S_{i,j}' des Referenz-Signals Si in der Mitte eines zum ersten Iterationsschritt gehörigen Zeitintervalls mittels Interpolation berechnet, wobei die beiden Grenzen des zum ersten Iterationsschritt gehörigen Zeitintervalls die beiden in Verfahrensschritt S110 identifizierten Abtastwerte S_{i,j}, S_{i,j-1} des Referenz-Signals Si sind, zwischen denen eine Über- oder Unterschreitung des Schwellwerts SWᵢ durch das Referenz-Signal Si erfolgt. In einem weiteren Iterationsschritt j werden die jeweiligen Grenzen des Zeitintervalls durch die links- oder rechtsseitige Grenze des im vorhergehenden Iterationsschritt j-1 betrachteten Zeitintervalls und einem im vorhergehenden Iterationsschritt j-1 ermittelten Abtastwert S_{i,j-1} des Referenz-Signals Sᵢ bestimmt, der in der Zeitintervallmitte des im vorhergehenden Iterationsschritt j-1 betrachteten Zeitintervalls positioniert ist.

Der in Verfahrensschritt S120 mittels Interpolation berechnete zusätzliche Abtastwert S_{i,j}' des Referenz-Signals Sᵢ, der in der Mitte des im jeweiligen Iterationsschritt j betrachteten Zeitintervalls positioniert ist, wird im darauf folgenden Verfahrensschritt S130 mit dem Pegel des Schwellwerts SWᵢ auf Über- oder -Unterschreitung verglichen.

Im darauf folgenden Verfahrensschritt S130 wird der Abstand des in Verfahrensschritt S120 ermittelten zusätzlichen Abtastwerts S_{i,j}' des Referenz-Signals Sᵢ, der in der Mitte des im jeweiligen Iterationsschritt j betrachteten Zeitintervalls positioniert ist, zum Schwellwert SWᵢ berechnet.

Ergibt der Vergleich des Pegelabstands zwischen dem zusätzlichen Abtastwert S_{i,j}' des Referenz-Signals Si und dem Schwellwert SWᵢ mit einem vorgegebenen Grenzwert G in Verfahrensschritt S140 noch keine Unterschreitung des Grenzwerts G durch den Pegelabstand zwischen dem zusätzlichen Abtastwert S_{i,j}' des Referenz-Signals Si und dem Schwellwert SWᵢ, so wird in Verfahrensschritt S150 der zusätzliche Abtastwert S_{i,j}' des Referenz-Signals Si mit dem Schwellwert SWᵢ auf Über- oder -Unterschreitung verglichen.

Auf den Vergleich in Verfahrensschritt S150 aufbauend wird im folgenden Verfahrensschritt S160 das im folgenden Iterationsschritt j+1 zu betrachtende Zeitintervall bestimmt. Die vom in Verfahrensschritt S120 betrachteten zusätzlichen Abtastwert S_{i,j}' des Referenz-Signals Si linksseitig gelegene Hälfte des im Iterationsschritt j betrachteten Zeitintervalls wird im folgenden Iterationsschritt j+1 weiterverfolgt, falls bei einer gewählten positiven Flankentriggerung der zusätzliche Abtastwert S_{i,j}' des Referenz-Signals Si den Schwellwert SWᵢ überschreitet oder bei einer gewählten negativen Flankentriggerung der zusätzliche Abtastwert S_{i,j}' des Referenz-Signals Si den Schwellwert SWᵢ unterschreitet. Die vom in Verfahrensschritt S120 betrachteten zusätzlichen Abtastwert S_{i,j}' des Referenz-Signals Si rechtsseitig gelegene Hälfte des im Iterationsschritt j betrachteten Zeitintervalls wird dagegen im folgenden Iterationsschritt j+1 weiterverfolgt, falls bei einer gewählten positiven Flankentriggerung der zusätzliche Abtastwert S_{i,j}' des Referenz-Signals Si den Schwellwert SWᵢ unterschreitet oder bei einer gewählten negativen Flankentriggerung der zusätzliche Abtastwert S_{i,j}' des Referenz-Signals Si den Schwellwert SWᵢ überschreitet. Anschließend wird in Verfahrensschritt S120 der zusätzliche Abtastwert S_{i,j+1}' des Referenz-Signals Sᵢ in der Mitte des im Iterationsschritt j+1 betrachteten Zeitintervalls mittels Interpolation bestimmt.

Ergibt dagegen der Vergleich des Pegelabstands zwischen dem zusätzlichen Abtastwert S_{i,j}' des Referenz-Signals Si und dem Schwellwert SWᵢ mit einem vorgegebenen Grenzwert G in Verfahrensschritt S140 eine Unterschreitung des Grenzwerts G durch den Pegelabstand zwischen dem zusätzlichen Abtastwert S_{i,j}' des Referenz-Signals Si und dem Schwellwert SWᵢ, so wird das Iterationsverfahren beendet und in Verfahrensschritt S170 der im aktuellen Iterationsschritt j ermittelte zusätzliche Abtastwert S_{i,j}' des Referenz-Signals Si als gesuchter Triggerzeitpunkt für das Triggersignal S_{TR}' festgelegt.

Fig. 11B zeigt am Beispiel eines sinusförmigen Signals und eines vorgegebenen Schwellwert, wie mit Hilfe der zweiten Ausführungsform des erfindungsgemäßen Verfahrens zur Triggersignal-Erzeugung durch iterative Ermittlung von zusätzlichen Abtastwerten S_{i,1}', S_{i,2}' und S_{i,3}' der zusätzliche Abtastwert S_{i,3}' des Referenz-Signals Sᵢ, der den minimalen Abstand zum Schwellwert aufweist, als Triggerzeitpunkt des Triggersignals bestimmt wird.

Die dritte Ausführungsform des erfindungsgemäßen Verfahrens zur Triggersignal-Erzeugung in Fig. 6C, die die zweite Ausführungsform des erfindungsgemäßen Verfahrens zur Triggersignal-Erzeugung in Fig. 6B erweitert, beinhaltet in ihren Verfahrensschritten S200, S210, S220, S230, S240, S250 und S260 die Verfahrensschritte S100, S110, S120, S130, S140, S150 und S160 der zweiten Ausführungsform des erfindungsgemäßen Verfahrens zur Triggersignal-Erzeugung.

Im abschließenden Verfahrensschritt S270 werden auf der Basis der in den letzten beiden Iterationsschritten j und j-1 ermittelten zusätzlichen Abtastwerte S_{i,j}' und S_{i,j-1}' des Referenz-Signals Si und ihren zugehörigen Abtastzeitpunkten sowie des Schwellwerts SWᵢ mittels linearer Interpolation der Schnittpunkt zwischen Schwellwert SWᵢ und Referenz-Signals Si als präziserer Triggerzeitpunkt des Triggersignals s_{TR}" berechnet.

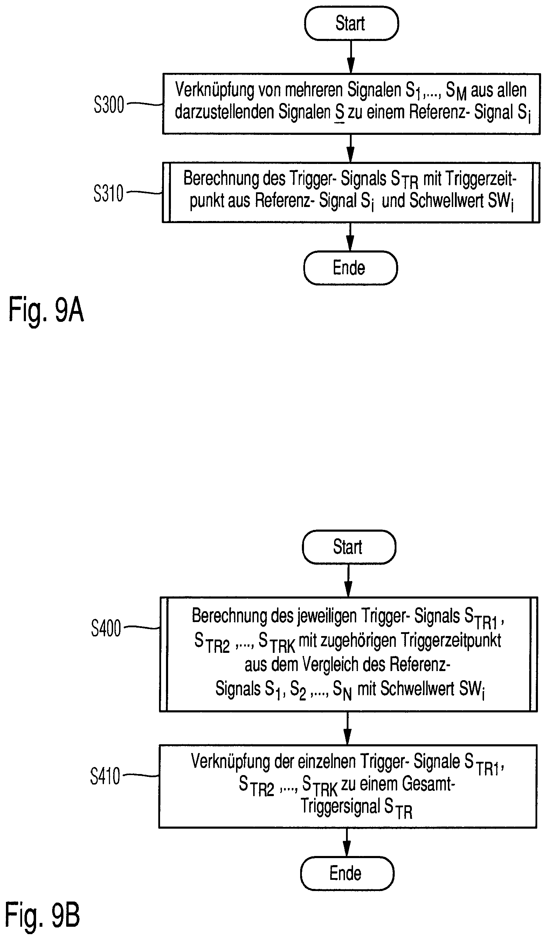

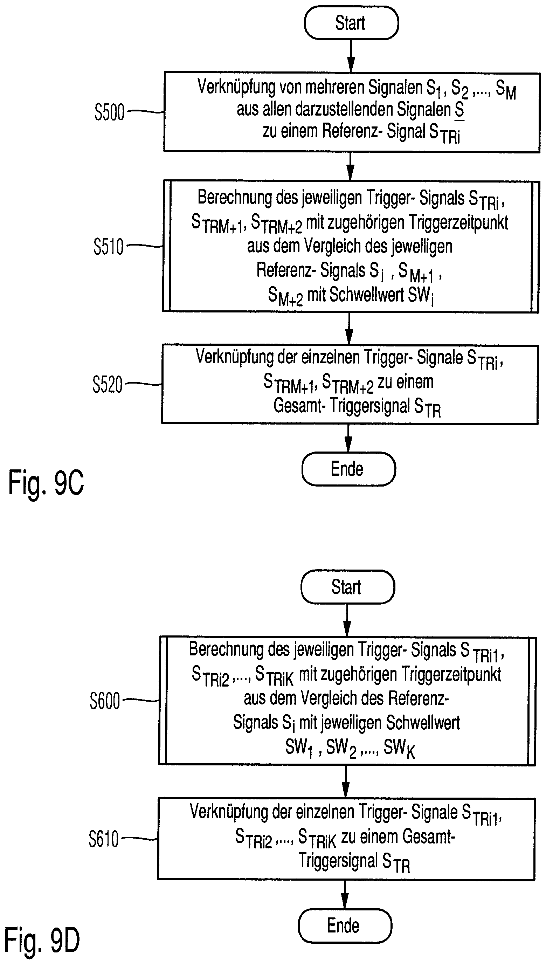

Im folgenden wird die erste, zweite, dritte und vierte Ausführungsform des erfindungsgemäßen Verfahrens zur digitalen Triggerung anhand der Figuren 9A, 9B, 9C und 9D beschrieben:
In Verfahrensschritt S300 der ersten Ausführungsform des erfindungsgemäßen Verfahrens zur digitalen Triggerung in Fig. 9A werden mehrere Signale S₁, S₂, ..., S_{M} aus allen auf dem digitalen Oszilloskop darzustellenden Signalen S, welche für die Triggerung herangezogen werden, in einer Triggerverknüpfungslogik 29 arithmetisch und/oder logisch miteinander verknüpft.

Im folgenden Verfahrensschritt S310 wird das Referenz-Signal Si unter Heranziehung der ersten, zweiten oder dritten Ausführungsform des erfindungsgemäßen Verfahrens zur Triggersignal-Erzeugung gemäß Fig. 8A, 8B und 8C mit einem Schwellwert SWᵢ in einer Triggersignal-Erzeugungseinheit 7, 7' oder 7" verglichen und aus dem Vergleichsergebnis ein Triggersignal S_{TR} mit einem korrekten Triggerzeitpunkt ohne Trigger-Offset bestimmt.

In Verfahrensschritt S400 der zweiten Ausführungsform des erfindungsgemäßen Verfahrens zur digitalen Triggerung in Fig. 9B werden mehrere Signale S₁, S₂, ..., S_{M} aus allen auf dem digitalen Oszilloskop darzustellenden Signalen S, welche für die Triggerung herangezogen werden, jeweils einzeln unter Heranziehung der ersten, zweiten oder dritten Ausführungsform des erfindungsgemäßen Verfahrens zur Triggersignal-Erzeugung gemäß Fig. 8A, 8B und 8C mit einem Schwellwert SWᵢ in einer Triggersignal-Erzeugungseinheit 7, 7' oder 7" verglichen und aus dem Vergleichsergebnis jeweils ein Triggersignal S_{TR1}, S_{TR2}, ... , S_{TRN} mit einem korrekten Triggerzeitpunkt ohne Trigger-Offset erzeugt.

Die in Verfahrensschritt S400 jeweils erzeugten Triggersignale S_{TR1}, S_{TR2}, ..., S_{TRN} werden anschließend in Verfahrensschritt S410 in einer Triggersignal-Verknüpfungseinheit 29' zu einem kombinierten Triggersignal S_{TR} miteinander verknüpft.

Die dritte Ausführungsform des erfindungsgemäßen Verfahrens zur digitalen Triggerung in Fig. 9C als Kombination der ersten und zweiten Ausführungsform des erfindungsgemäßen Verfahrens zur digitalen Triggerung in Fig. 9A und 9B enthält in ihrem ersten Verfahrensschritt S500 den Verfahrensschritt S300 der ersten Ausführungsform des erfindungsgemäßen Verfahrens zur digitalen Triggerung in Fig. 9A und in den nachfolgenden Verfahrensschritten S510 und S520 die Verfahrensschritte S400 und S410 der zweiten Ausführungsform des erfindungsgemäßen Verfahrens zur digitalen Triggerung in Fig. 9B.

In Verfahrensschritt S600 der vierten Ausführungsform des erfindungsgemäßen Verfahrens zur digitalen Triggerung in Fig. 9D wird ein für die Triggerung vorgesehenes Signal Si aus allen am digitalen Oszilloskop darzustellenden Signalen _S unter Heranziehung der ersten, zweiten oder dritten Ausführungsform des erfindungsgemäßen Verfahrens zur digitalen Triggersignal-Erzeugung gemäß Fig. 8A, 8B und 8C mit jeweils einem unterschiedlichen Schwellwert SW₁, SW₂,..., SW_{K} in jeweils einer Triggersignal-Erzeugungseinheit 7, 7' oder 7" verglichen und aus dem Vergleichsergebnis jeweils ein Triggersignal S_{TR1}, S_{TR2},..., S_{TRN} mit einem korrekten Triggerzeitpunkt ohne Trigger-Offset erzeugt.

Die in Verfahrensschritt S600 jeweils erzeugten Triggersignale S_{TR1}, S_{TR2}, ..., S_{TRN} werden im anschließenden Verfahrensschritt S610 in einer Triggersignal-Verknüpfungseinheit 29' zu einem kombinierten Triggersignal S_{TR} miteinander verknüpft.

Ergibt der Vergleich des Referenz-Signals Si mit dem Schwellwert SWᵢ im Komparator 8, 8' oder 8", dass die Pegel zweier aufeinander folgender Abtastwerte S_{i,j}, S_{i,j-1} des Referenz-Signals Si unterhalb des Schwellwerts SWᵢ liegen, so kann es u. U. vorkommen, dass aufgrund einer zu niedrigen Abtastrate das Referenz-Signal Si zwischen den beiden aufeinander folgenden Abtastwerten S_{i,j}, S_{i,j-1} des Referenz-Signals Si den Schwellwert SWᵢ überschreitet, ohne dass eine Triggerung bewirkt wird. Entsprechend kann es auch vorkommen, dass im Falle eines Überschreitens des Schwellwerts SWᵢ durch die beiden aufeinander folgenden Abtastwerte S_{i,j}, S_{i,j-1} des Referenz-Signals Sᵢ das Referenz-Signal Si zwischen den beiden aufeinander folgenden Abtastwerten S_{i,j}, S_{i,j-1} aufgrund einer zu niedrigen Abtastrate den Schwellwert SWᵢ unterschreitet, ohne dass eine Triggerung bewirkt wird.

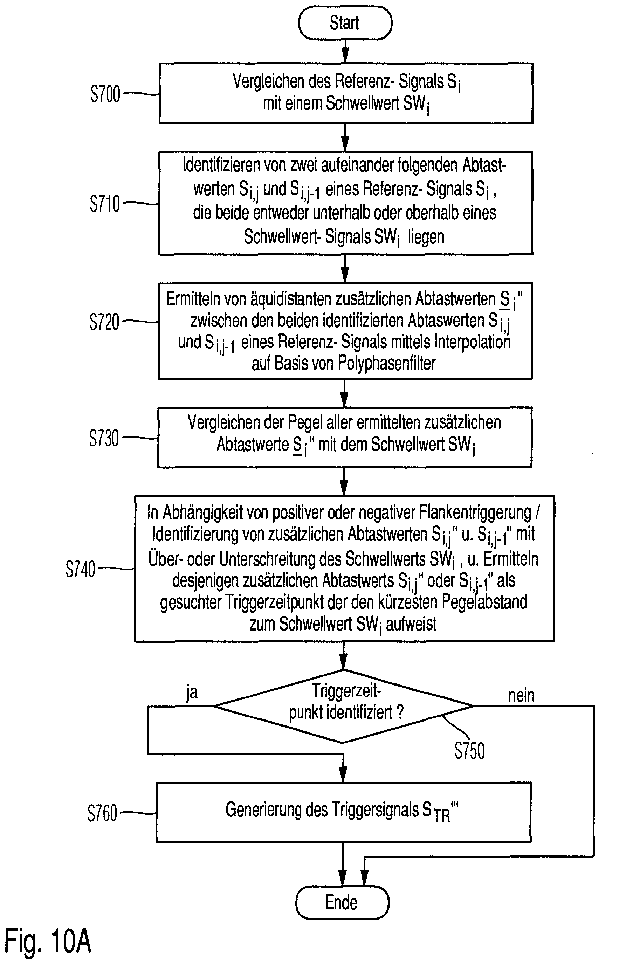

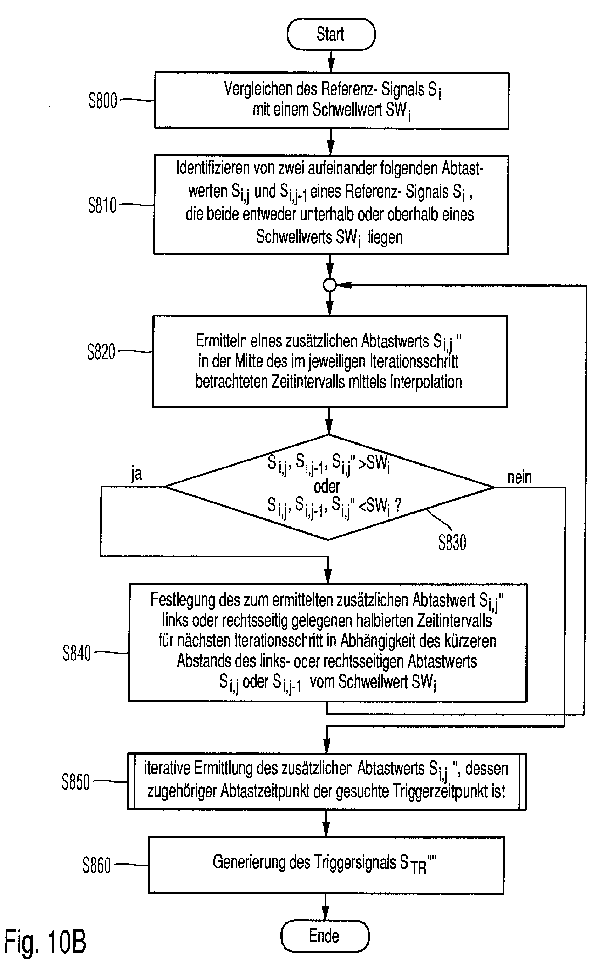

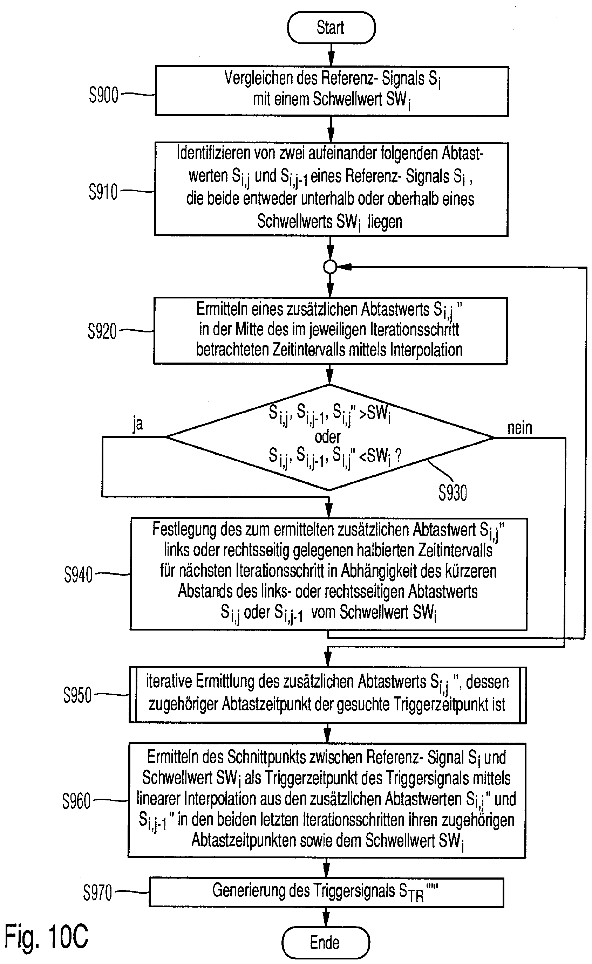

Hierzu wird die erste, zweite und dritte Ausführungsform des erfindungsgemäßen Verfahrens zur Triggersignal-Erzeugung in den Fig. 8A, 8B und 8C herangezogen, um über die Ermittlung von zusätzlichen Abtastwerten S_{i,j}' zwischen den beiden aufeinander folgenden Abtastwerten S_{i,j} und S_{i,j-1} ein Über- oder Unterschreiten des Schwellwerts SWᵢ durch das Referenz-Signal Si eindeutig zu identifizieren oder eindeutig nicht zu identifizieren. Die daraus entwickelte vierte, fünfte und sechste Ausführungsform des erfindungsgemäßen Verfahrens zur Triggersignal-Erzeugung ist in den Fig. 10a, 10B und 10C dargestellt.

Die vierte Ausführungsform des erfindungsgemäßen Verfahrens zur Triggersignal-Erzeugung in Fig. 10A entspricht in ihrem erste Verfahrensschritt S700 dem ersten Verfahrensschritt S10 der ersten Ausführungsform.

Der darauf folgende zweite Verfahrensschritt S710 der vierten Ausführungsform untersucht im Gegensatz zum zweiten Verfahrensschritt S20 der ersten Ausführungsform, ob zwei aufeinanderfolgende Abtastwerte S_{i,j} und S_{i,j-1} des Referenz-Signals Si jeweils unterhalb oder oberhalb des Schwellwerts SWᵢ liegen.

Liegen die Abtastwerte S_{i,j} und S_{i,j-1} des Referenz-Signals Si jeweils beide oberhalb oder unterhalb des Schwellwerts SWᵢ, so werden im darauf folgenden Verfahrensschritt S720 mittels Interpolation zusätzliche Abtastwerte Sᵢ" zwischen den beiden in Verfahrensschritt S710 identifizierten Abtastwerte S_{i,j} und S_{i,j-1} des Referenz-Signals Sᵢ berechnet.

Die ermittelten zusätzlichen Abtastwerte Sᵢ" werden im folgenden Verfahrensschritt S730 mit dem Schwellwert SWᵢ verglichen.

Im Verfahrensschritt S740 wird in Abhängigkeit von einer positiven oder negativen Flankentriggerung diejenigen zusätzlichen Abtastwerte S_{i,j}" und S_{i,j-1}" des Referenz-Signals Si identifiziert, zwischen denen der Schwellwert SWᵢ liegt, und bei einer Identifizierung schließlich derjenige zusätzliche Abtastwert S_{i,j}" oder S_{i,j-1}" des Referenz-Signals Si, der den kürzesten Abstand zum Schwellwert SWᵢ aufweist, als gesuchter Triggerzeitpunkt für das Triggersignal S_{TR}‴ ermittelt.

Wird gemäß Verfahrensschritt S750 ein Triggerereignis identifiziert, so wird in Verfahrensschritt S760 ein Triggersignal s_{TR}‴ erzeugt, das mit dem identifizierten Triggerzeitpunkt aktiviert ist.

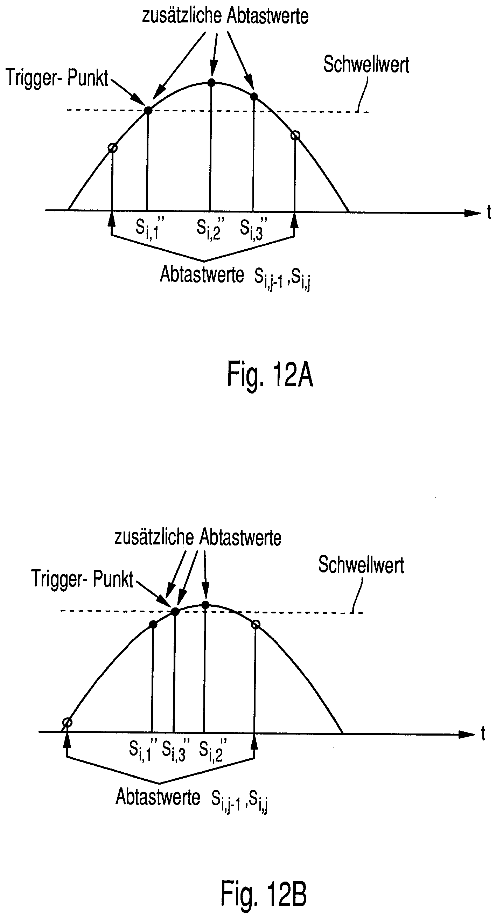

Fig. 12A zeigt für ein sinusförmiges Referenz-Signal Si und einen gegebenen Schwellwert SWᵢ die äquidistanten zusätzlichen Abtastwerte S_{i,1}", S_{i,2}" und S_{i,3}" des Referenz-Signals Si zwischen den beiden Abtastwerten S_{i,j} und S_{i,j-1} des Referenz-Signals Sᵢ, deren Pegel beide unterhalb des Schwellwerts liegen, sowie den als Trigger-Punkt identifizierten zusätzlichen Abtastwert S_{i,3}".

Die fünfte Ausführungsform des erfindungsgemäßen Verfahrens zur Triggersignal-Erzeugung in Fig. 10B entspricht in ihrem erste Verfahrensschritt S800 dem ersten Verfahrensschritt S100 der zweiten Ausführungsform.

In Verfahrensschritt S810 der fünften Ausführungsform werden in Abgrenzung zu Verfahrensschritt S110 der zweiten Ausführungsform zwei aufeinander folgende Abtastwerte S_{i,j} und S_{i,j-1} des Referenz-Signals Si identifiziert, die beide entweder unterhalb oder oberhalb des Schwellwerts SWᵢ liegen.

Im darauf folgenden Verfahrensschritt S820 wird im Rahmen einer Iteration ein zusätzlicher Abtastwert S_{i,j}" des Referenz-Signals Si mittels Interpolation berechnet, der sich in der Mitte des im jeweiligen Iterationsschritt betrachteten Zeitintervalls befindet. Im ersten Iterationsschritt wird das Zeitintervall zwischen den aufeinander folgenden Abtastwerten S_{i,j} und S_{i,j-1} des Referenz-Signals Si betrachtet.

Im nächsten Verfahrensschritt S830 wird geprüft, ob die aufeinander folgende Abtastwerte S_{i,j} und S_{i,j-1} sowie der im aktuellen Iterationsschritt ermittelte zusätzliche Abtastwert S_{i,j}" des Referenz-Signals Si alle oberhalb oder alle unterhalb des Schwellwerts SWᵢ liegen.

Ist dies der Fall, so muß in einem weiteren Iterationsschritt ein zusätzlicher Abtastwert S_{i,j}" des Referenz-Signals Si innerhalb eines Zeitintervalls ermittelt werden, das sich innerhalb des Zeitintervalls des aktuellen Iterationsschritt befindet und zu diesem halbiert ist. Hierzu wird in Verfahrensschritt S840 dasjenige halbierte Zeitintervall, das zum im aktuellen Iterationsschritt ermittelten zusätzlichen Abtastwert S_{i,j}" des Referenz-Signals Si entweder links- oder rechtsseitig gelegen ist, ausgewählt, das zwischen demjenigen Abtastwert S_{i,j} und S_{i,j-1} und dem im aktuellen Iterationsschritt ermittelten zusätzlichen Abtastwert S_{i,j}" des Referenz-Signals Si liegt, der den kürzeren Pegelabstand zum Schwellwert SWᵢ aufweist. Im allgemeinen ist innerhalb von ein bis zwei Iterationszyklen ein Über- oder Unterschreiten des Schwellwerts SWᵢ durch das Referenz-Signal Si eindeutig identifiziert oder eindeutig nicht identifiziert (wegen Frequenzbegrenzung des Referenz-Signals Si aufgrund des Abtasttheorems).

Wird in Verfahrensschritt S830 ein Über- oder Unterschreiten des Schwellwerts SWᵢ durch das Referenz-Signal Si registriert, so wird in Verfahrensschritt S850 durch die iterative Berechnung von zusätzlichen Abtastwerten Sᵢ" innerhalb des im letzten Iterationsschritt betrachteten Zeitintervalls ein präziserer Schnittpunkt zwischen Schwellwert SWᵢ und Referenz-Signal Si ermittelt. Verfahrensschritt S850 beinhaltet im wesentlichen die Verfahrensschritte S120 bis S160 der zweiten Ausführungsform des erfindungsgemäßen Verfahrens zur Triggersignal-Erzeugung in Fig. 8B.

Schließlich wird im abschließenden Verfahrensschritt S860 auf der Basis des in Verfahrensschritt S850 ermittelten Triggerzeitpunkt ein Triggersignal s_{TR}ʺʺ generiert.

In Fig. 12B ist die Annäherung der zusätzliche Abtastwerte S_{i,1}", S_{i,2}" und S_{i,3}" des Referenz-Signals Si an den Trigger-Punkt (zusätzlicher Abtastwert S_{i,3}") mit Hilfe der fünften Ausführungsform des erfindungsgemäßen Verfahrens zur Triggersignal-Erzeugung auf der Basis einer iterativen Zeitintervalls-Halbierung dargestellt.

In Fig. 10C ist eine sechste Ausführungsform des erfindungsgemäßen Verfahrens zur Triggersignal-Erzeugung dargestellt, deren Verfahrensschritte S800 bis S850 den Verfahrensschritten S900 bis S950 der fünften Ausführungsform des erfindungsgemäßen Verfahrens zur Triggersignal-Erzeugung in Fig. 10A entsprechen.

In Verfahrensschritt S960 der sechsten Ausführungsform wird in Analogie zu Verfahrensschritt S270 der dritten Ausführungsform mittels linearer Interpolation zwischen den im letzten Iterationsschritt des Verfahrensschrittes S950 betrachteten Zeitintervalls mit seinen Zeitintervallsgrenzen - den in den letzten beiden Iterationsschritten ermittelten zusätzlichen Abtastwerten S_{i,j}" und S_{i,j+1}" des Referenz-Signals Sᵢ - ein präziserer Triggerzeitpunkt als Schnittpunkt zwischen Schwellwert SWᵢ und Referenz-Signal Si berechnet.

Schließlich wird im abschließenden Verfahrensschritt S970 auf der Basis des in Verfahrensschritt S960 ermittelten Triggerzeitpunkts ein Triggersignal s_{TR}‴ʺ erzeugt.

Die Erfindung ist nicht auf die dargestellten Ausführungsformen beschränkt. Insbesondere sind neben Interpolationsverfahren mit Polyphasenfilter auch andere Interpolationsverfahren von der Erfindung abgedeckt.

## Patentansprüche

1. Digitales Oszilloskop bestehend aus einem Vorverstärker (1) zur Pegelanpassung von mindestens einem auf dem digitalen Oszilloskop darzustellenden Signal (S), einem Analog-Digital-Wandler (2) zur Analog-Digital-Wandlung der darzustellenden Signale (S), einem digitalen Triggersystem (5, 5', 5", 5‴) zur Ermittlung eines Triggerzeitpunkts und einer Aufzeichnungseinheit (6) zur Darstellung der darzustellenden Signale (S),
wobei das digitale Triggersystem (5, 5', 5", 5‴) einen auftretenden Triggerzeitpunkt ermittelt, der gegenüber der Abtastrate des Analog-Digital-Wandlers (2) eine höhere zeitliche Auflösung aufweist und
wobei dem Analog-Digital-Wandler (2) ein Entzerrungssystem (4) zur Kompensation linearer und nichtlinearer Verzerrungen in jedem der darzustellenden Signale (S) nachgeschaltet ist,
**dadurch gekennzeichnet,**
**dass** diejenigen Abtastwerte des digitalisierten entzerrten Messsignals auf einem Bildschirm der Aufzeichnungseinheit (6) des digitalen Oszilloskops dargestellt werden, die gleichzeitig mit einem Triggersignal oder zeitlich dem Triggersignal unmittelbar nachfolgend erfaßt werden, und dass das Triggersystem (5, 5', 5", 5‴) eine Triggerverknüpfungslogik (29) aufweist, die ausgebildet ist, zur Bildung eines Referenz-Signals (Sᵢ) mehrere Signale (S₁, S₂, ..., S_{M}) aus allen am digitalen Oszilloskop darzustellenden Signalen (S) zu verknüpfen, wobei das Referenz-Signal (Sᵢ) in einer Triggersignal-Erzeugungseinheit (7, 7', 7") des Triggersystems (5, 5', 5", 5‴) mit einem Schwellwert (SWᵢ) hinsichtlich Über- oder Unterschreitung im Hinblick auf die Ermittlung eines Triggerzeitpunkts verglichen wird, und wobei mit Eintritt des Triggerzeitpunkts das Triggersignal am Ausgang der Triggersignal-Erzeugungseinheit (7, 7', 7") aktiviert wird.

2. Digitales Oszilloskop nach Anspruch 1,
**dadurch gekennzeichnet,**
**dass** dem digitalen Triggersystem (5, 5', 5", 5‴) und der Aufzeichnungseinheit (6) eine Einheit (3) zur Kompensation von Übertragungszeit-Unterschieden in den zu den darzustellenden Signalen (S) gehörigen Messkanälen vorgeschaltet ist.

## Claims

1. Digital oscilloscope consisting of a preamplifier (1) for level adaptation of at least one signal (S) to be displayed on the digital oscilloscope, an analog-digital converter (2) for analog-digital conversion of the signals (S) to be displayed, a digital trigger system (5, 5', 5", 5‴) for determining a trigger time, and a recording unit (6) for displaying the signals (S) to be displayed,
the digital trigger system (5, 5', 5", 5‴) determining an occurring trigger time which has a higher temporal resolution compared to the sampling rate of the analog-digital converter (2), and
an equalization system (4) for compensating for linear and nonlinear distortions in each of the signals (S) to be displayed being connected downstream of the analog-digital converter (2),
**characterized in that**
the sample values of the digitized equalized measurement signal are displayed on a screen of the recording unit (6) of the digital oscilloscope, which sample values are detected simultaneously with a trigger signal or temporally immediately following the trigger signal, **and**
**in that** the trigger system (5, 5', 5", 5‴) comprises a trigger linking logic circuit (29) which is designed to link a plurality of signals (S₁, S₂, ..., S_{M}) from all signals (S) to be displayed on the digital oscilloscope in order to form a reference signal (Sᵢ), the reference signal (Sᵢ) being compared, in respect of exceeding or falling below, with a threshold value (SWᵢ) in a trigger signal generation unit (7, 7', 7") of the trigger system (5, 5', 5", 5‴), with regard to determining a trigger time, and the trigger signal being activated at the output of the trigger signal generation unit (7, 7', 7") when the trigger time occurs.

2. Digital oscilloscope according to claim 1,
**characterized in that**
a unit (3) for compensating for transmission time differences in the measurement channels associated with signals (S) to be displayed is connected upstream of the digital trigger system (5, 5', 5", 5‴) and the recording unit (6).

## Revendications

1. Oscilloscope numérique constitué d'un préamplificateur (1) permettant d'adapter le niveau d'au moins un signal (S) à représenter sur l'oscilloscope numérique, un convertisseur analogique-numérique (2) pour la conversion analogique-numérique des signaux (S) à représenter, un système de déclenchement (5, 5', 5", 5‴) numérique permettant de déterminer un instant de déclenchement et une unité d'enregistrement (6) permettant de représenter les signaux (S) à représenter,
dans lequel le système de déclenchement (5, 5', 5", 5‴) numérique détermine un instant de déclenchement survenant qui présente une résolution temporelle plus élevée par rapport au taux d'échantillonnage du convertisseur analogique-numérique (2) et
dans lequel un système d'égalisation (4) permettant de compenser des distorsions linéaires et non linéaires dans chacun des signaux (S) à représenter est monté en aval du convertisseur analogique-numérique (2),
**caractérisé en ce que**
les valeurs d'échantillonnage du signal de mesure égalisé numérisé sont représentées sur un écran de l'unité d'enregistrement (6) de l'oscilloscope numérique, lesquelles valeurs d'échantillonnage sont recueillies simultanément avec un signal de déclenchement ou immédiatement après le signal de déclenchement dans le temps, et
**que** le système de déclenchement (5, 5', 5", 5‴) présente une logique combinatoire de déclenchement (29) qui est configurée pour combiner plusieurs signaux (S₁, S₂, ..., S_{M}) parmi tous les signaux (S) à représenter sur l'oscilloscope numérique pour former un signal de référence (Sᵢ), dans lequel le signal de référence (Sᵢ) est comparé, dans une unité de génération de signal de déclenchement (7, 7', 7") du système de déclenchement (5, 5', 5", 5‴), avec une valeur seuil (SWᵢ) en termes de dépassement ou de non-atteinte en vue de la détermination d'un instant de déclenchement, et dans lequel, lorsque l'instant de déclenchement arrive, le signal de déclenchement est activé à la sortie de l'unité de génération de signal de déclenchement (7, 7', 7").

2. Oscilloscope numérique selon la revendication 1,
**caractérisé en ce que**
une unité (3) permettant de compenser des différences de temps de transmission dans les canaux de mesure associés aux signaux (S) à représenter est montée en amont du système de déclenchement (5, 5', 5", 5‴) numérique et de l'unité d'enregistrement (6).
